# EUROPEAN PATENT APPLICATION

(11) **EP 2 903 402 A1**
(43) Date of publication of application: **05.08.2015**
(21) Application number: 13842961.8
(22) Date of filing: 20.09.2013
(51) Int. Cl.: H05K 9/00, B60R 16/02, H01B 7/17, H01B 7/20, H01B 13/22

(54) **SHIELDED CONDUCTOR PATH AND METHOD FOR PRODUCING SAME**

(30) Priority: 28.09.2012 JP 2012215604
(71) Applicant: Yazaki Corporation, Tokyo 108-0073 (JP)
(72) Inventor: YANAGIHARA, Yusuke, Kakegawa-shi Shizuoka 437-1421 (JP)
(74) Representative: Hoffmann Eitle
(86) International application number: PCT/JP2013/075474
(87) International publication number: WO 2014/050737

(57) **Abstract**

A shield conductive path includes a shield pipe (2) having rigidity for holding a cylindrical shape and provided with a plurality of wire holding concave portions (3) extending in a longitudinal direction at positions spaced apart in a circumferential direction at a cylindrical inner peripheral face side; and a plurality of wires (10) held on each of the plurality of wire holding concave portions (3).

## Description

### TECHNICAL FIELD

The present invention relates to a shield conductive path and a manufacturing method thereof.

### BACKGROUND ART

For example, devices such as an inverter apparatus and a motor in an electric vehicle are electrically connected with each other via a shield conductive path having a shield function (electric magnetic shield, magnetic shield). The shield conductive path including a plurality of wires, each of which is constituted of a shield wire, is known. However, a shield layer of each shield wire needs to be connected to a shield case and the like on a vehicle body side, thereby deteriorating connection operability.

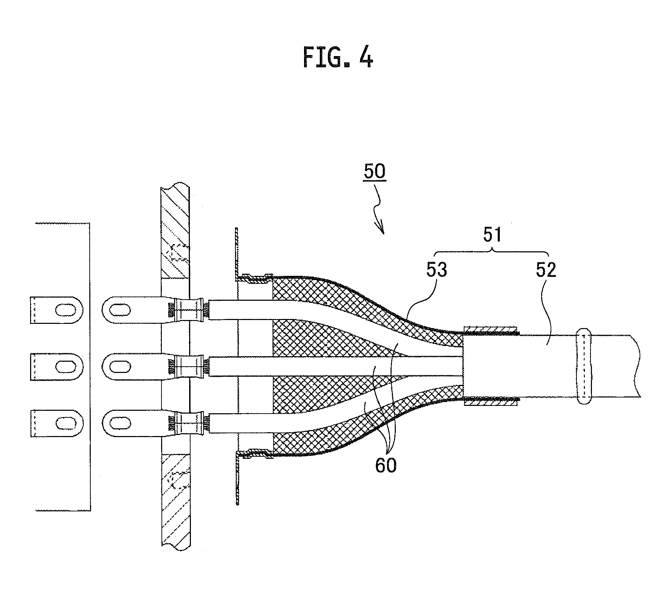

As illustrated in Fig. 4, a shield conductive path 50 of prior art that has solved the problem described above has been suggested (refer to the patent literature 1). The shield conductive path 50 includes a cylindrical shield member 51, and a plurality of wires 60 not having a shield function stored in the shield member 51. The shield member 51 is constituted of a shield pipe 52 formed of conductive metal and a cylindrical braided wire 53 connected to an end portion of the shield pipe 52 and knitted with a metal thin wire.

According to the shield conductive path 50, only the cylindrical braided wire may be connected to the shield case (not illustrated) and the like on a ground side regardless of the number of the wires 60 provided therein, thereby resulting in excellent connection operability.

### CITATION LIST

### PATENT LITERATURE

Patent Literature 1: Japanese Patent Laid-Open Publication No. 2004-171952

### SUMMARY OF INVENTION

### TECHNICAL PROBLEM

However, the shield conductive path 50 of the priority art has a problem in which, since the plurality of wires 60 not having a shield function is stored in the shield member 51 in a state of being located close to each other, stray capacitance between the wires 60 and mutual inductance may generate cross talk noise.

Therefore, the present invention has been made in order to solve the above-described problems, and an object of the present invention is to provide a shield conductive path capable of achieving connection operability with a ground side and also capable of suppressing generation of cross talk noise between wires and a method thereof.

### SOLUTION TO PROBLEM

According to the present invention, a shield conductive path includes a shield pipe having rigidity for holding a cylindrical shape and provided with a plurality of wire holding concave portions extending in a longitudinal direction at positions spaced apart in a circumferential direction at a cylindrical inner peripheral face side; and a plurality of wires held on each of the plurality of wire holding concave portions.

According to another present invention, a manufacturing method of a shield conductive path includes the steps of: placing a wire on each of a plurality of wire holding concave portions formed spaced apart on a shield plate in a plate-like shape; molding a cylindrical shield pipe having rigidity for holding a cylindrical shape, by folding the shield plate into a cylindrical shape with the wire holding concave portion having the wire placed thereon being set to be an inner peripheral face side; and holding the wire on each of the plurality of wire holding concave portions whose width dimension is narrowed by folding molding.

### BRIEF DESCRIPTION OF DRAWINGS

[Fig. 1] Fig. 1(a) and Fig. 1(b) illustrate a first embodiment of the present invention; in which Fig. 1(a) is a perspective view of a shield conductive path, and Fig. 1(b) is a cross-sectional view thereof.
[Fig. 2] Fig. 2(a) and Fig. 2(b) illustrate a second embodiment of the present invention; in which Fig. 2(a) is a perspective view of a shield conductive path, and Fig. 2(b) is a cross-sectional view thereof.
[Fig. 3] Fig. 3(a) and Fig. 3(b) illustrate a third embodiment of the present invention; in which Fig. 3(a) is a broken perspective view of a shield conductive path, and Fig. 3(b) is a perspective view of a shield plate in a plate-like shape.
[Fig. 4] Fig. 4 is a cross-sectional view of a shield conductive path of a prior art.

### DESCRIPTION OF EMBODIMENTS

Hereinafter, the embodiments of the present invention will be described with reference to drawings.

### (First Embodiment)

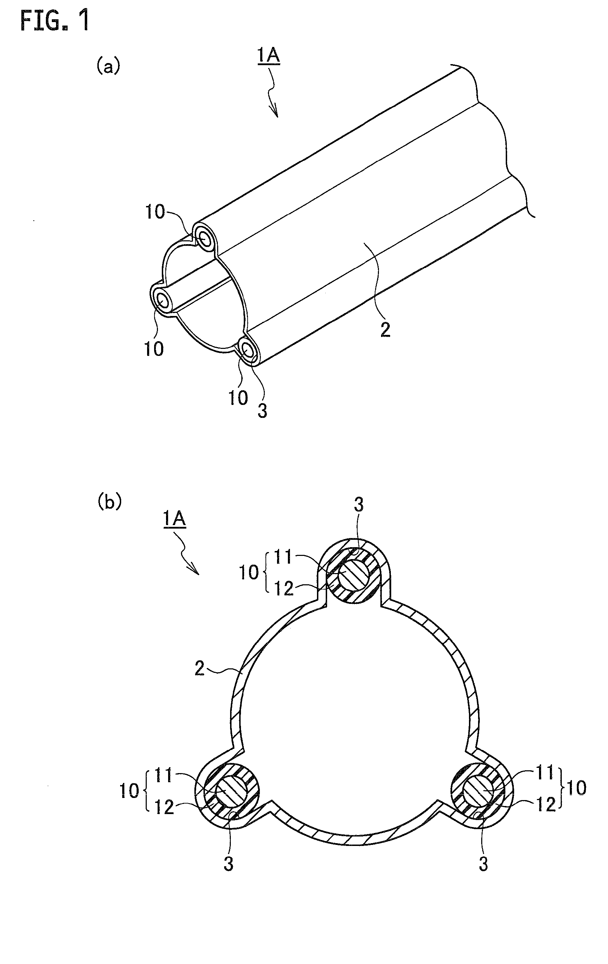

Fig. 1(a) and Fig. 1(b) illustrate the first embodiment of the present invention. The shield conductive path 1A according to the first embodiment includes a shield pipe 2 and three wires 10 held in the shield pipe 2. The shield pipe 2 has rigidity for holding a cylindrical shape and is formed of a conductive member achieving a shield function. The conductive member is, for example, conductive metal (iron, aluminum, copper, and stainless). The shield pipe 2 has a substantially cylindrical shape and includes protruding portions on the outer peripheral side at three portions in the circumferential direction. The shield pipe 2 is provided with, on the inner peripheral face side of the protruding portions, a plurality of (herein, three) wire holding concave portions 3 extending in the longitudinal direction at positions spaced apart in the circumferential direction. The three wire holding concave portions 3 are arranged at equal interval positions (intervals of 120 degrees at the center angle). Each of the wire holding concave portions 3 is a U-shaped groove, and a dimension of its opening is set to be slightly smaller than that of an outer diameter of each wire 10. With this arrangement, each of the wires 10 is held by a fitting force of the shield pipe 2, on the wire holding concave portion 3.

Each of the wires 10 includes a conductive body 11 and an insulating outer skin 12 coating the outer periphery of the conductive body 11. Each of the wires 10 has no shield function.

As to the shield conductive path 1A, when only one portion of the shield pipe 2 is electrically connected to the ground side (e.g., shield case), the shield function can be achieved. Namely, the shield pipe 2 shields outer noise, and also shields leakage of noise from each of the wires 10 to the outside. In addition, since the respective wires 10 in the shield pipe 2 are stored with a sufficient space therebetween, the stray capacitance or the mutual inductance between the respective wires 10 is suppressed small. As described above, the connection operability with the ground side is improved, and further generation of the cross talk noise among the respective wires 10 can be suppressed.

Since the respective wires 10 are stored in the shield pipe 2 having rigidity for holding the cylindrical shape, the space between the respective wires 10 can be securely maintained by the shield pipe 2. Furthermore, interference of foreign substances to the wires 10 can be securely prevented.

Since the respective wires 10 are stored at regular intervals in the shield pipe 2, the generation of the cross talk noise can be uniformly suppressed between whole wires 10.

### (Second Embodiment)

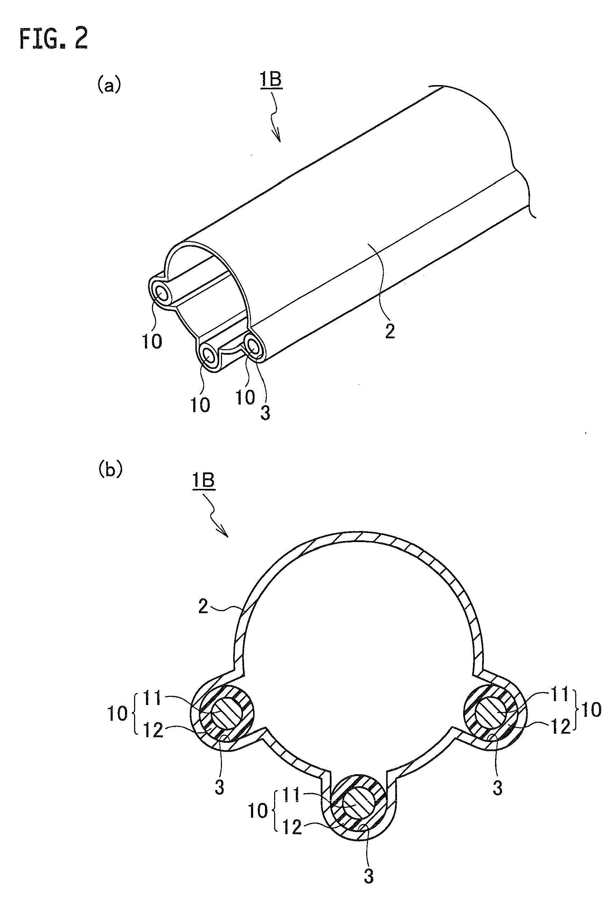

Fig. 2(a) and Fig. 2(b) illustrate the second embodiment of the present invention. The shield conductive path 1B according to the second embodiment is different from that according to the first embodiment in that the wire holding concave portions 3 of the shield pipe 2 are disposed at different intervals. Since other configurations are the same as those of the first embodiment, the explanation thereof will be omitted. The same configuration portion as that of the first embodiment in the drawing is clarified by applying the same reference sign.

As the shield conductive path 1B of the second embodiment, in the same manner as the first embodiment, when only one portion of the shield pipe 2 is electrically connected to the grounding wire side (e.g., shield case), the shield function can be achieved. Namely, the shield pipe 2 shields the outer noise, and also shields the leakage of the noise from each of the wires 10 to the outside. In addition, since the respective wires 10 in the shield pipe 2 are stored with the sufficient space therebetween, the stray capacitance and the mutual inductance between the respective wires 10 is suppressed small. For the reasons described above, the connection operability with the ground side is improved, and further generation of the cross talk noise among the respective wires 10 can be suppressed.

Since the respective wires 10 are stored in the shield pipe 2 having rigidity for holding the cylindrical shape, the space between the respective wires 10 can be securely maintained by the shield pipe 2. Furthermore, interference of foreign substances to the wires 10 can be securely prevented.

### (Third Embodiment)

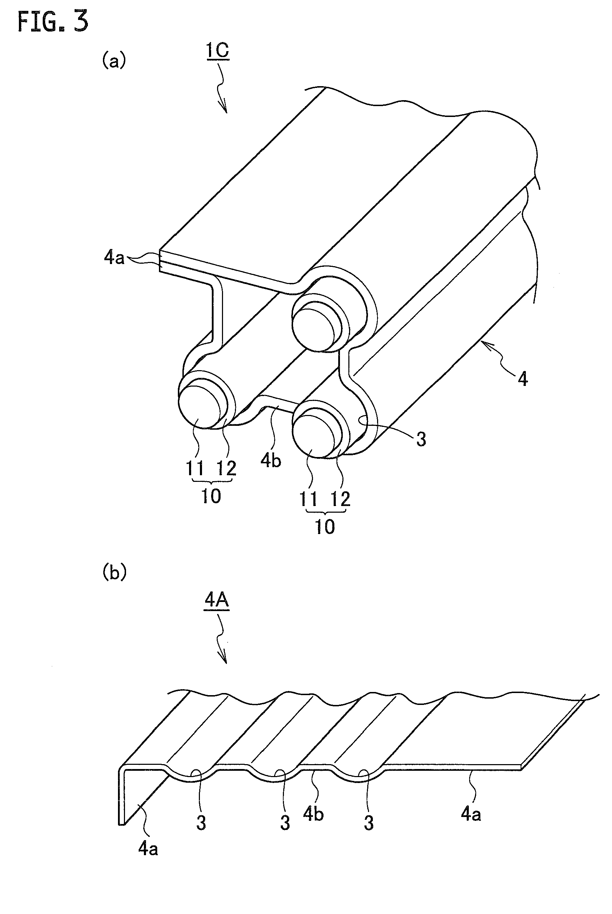

Fig. 3(a) and Fig. 3(b) illustrate the third embodiment of the present invention. The shield conductive path 1C according to the third embodiment includes the shield pipe 4 having a different configuration from that of the first embodiment. The same reference sign is applied to the same configuration portion as that of the first embodiment in the drawing, and the explanation thereof will be omitted.

Hereinafter, a configuration of the shield pipe 4 will be described. The shield pipe 4 according to the third embodiment has, as illustrated in Fig. 3(a), a square pole shape, and is manufactured by folding a shield plate 4A in a plate-like shape. As illustrated in Fig. 3(b), the shield plate 4A in a plate-like shape is constituted of a pair of connection portions 4a disposed at its both ends, and a folding plate portion 4b disposed between the pair of the connection portions 4a. A plurality of (herein, three) wire holding concave portions 3 spaced apart therebetween is formed at the folding plate portion 4b.

Hereinafter, a manufacturing method of the shield conductive path 1C will be described. First, the wires 10 are respectively placed on each of the wires holding concave portion 3 of the shield plate 4A in a plate-like shape. Next, the cylindrical shield pipe 4 having rigidity for holding the cylindrical shape is molded by folding the shield plate 4A into a cylindrical shape such that a wire holding concave portion 3 side having the wires 10 placed thereon is set to be an inner peripheral face side. The width dimension (opening dimension) of the wire holding concave portion 3 is narrowed by folding molding to hold the wire 10, and thus each of the wires 10 is held in each of the wires holding concave portion 3. Finally, manufacturing of the shield conductive path 1C is completed by firm fixing of the pair of the connection portions 4a abutted to each other.

For the same reasons as that of the first embodiment, even the shield conductive path 1C manufactured as described above has excellent connection operability with the grounding wire side, and further the generation of the cross talk noise between the respective wires 10 can be suppressed.

When the wire 10 is simply placed on the wire holding concave portion 3 of the shield plate 4A, the width dimension (opening dimension) of the wire holding concave portion 3 is narrowed to hold the wire 10 in the subsequent processing for folding the shield plate 4A., and thus operability for inserting the wire is excellent in comparison with an operation for inserting the wire 10 into the wire holding concave portion 3 of the shield pipe 4, operability for inserting the wire can be more improved.

### (Modification)

According to each embodiment, the shield pipes 2 and 4 each may be a conductive member as long as they exert the shield function as described above. In addition to the conductive metal described above, a conductive resin material, a material obtained by applying conductive plating or coating on the surface of an insulating resin, or a material obtained by sticking a metal foil on the surface of the insulating resin may be adopted.

In each embodiment, a case of three wire holding concave portions 3 and three wires 10 has been shown, but a plurality of (two or more) wire holding concave portions 3 and a plurality of (two or more) wires 10 may be adopted.

The shield pipes 2 and 4 have each a substantially cylindrical shape or a square pole shape, but any shape of a pipe may be adopted.

The present application claims the priority based on Japanese Patent Application No. 2012-215604 filed on the 28th September 2012, and the entire content of the application is incorporated in the present specification as a reference.

### INDUSTRIAL APPLICABILITY

According to the present invention, only one portion of a shield pipe may be electrically connected to a ground side, and in addition, since the respective wires in the shield pipe are stored spaced apart therebetween, stray capacitance and mutual inductance between the respective wires can be reduced. Connection operability with a ground side can be improved, and the generation of the cross talk noise between the respective wires can be suppressed.

### REFERENCE SIGNS LIST

- 1A, 1B, 1C: shield conductive path
- 2, 4: shield pipe
- 3: wire holding concave portion
- 4A: shield plate
- 10: wire

## Claims

1. A shield conductive path, comprising:
a shield pipe having rigidity for holding a cylindrical shape and provided with a plurality of wire holding concave portions extending in a longitudinal direction at positions spaced apart in a circumferential direction at a cylindrical inner peripheral face side; and
a plurality of wires held on each of the plurality of wire holding concave portions.

2. A manufacturing method of a shield conductive path, comprising the steps of:
placing a wire on each of a plurality of wire holding concave portions formed spaced apart on a shield plate in a plate-like shape;
molding a cylindrical shield pipe having rigidity for holding a cylindrical shape, by folding the shield plate into a cylindrical shape with the wire holding concave portion having the wire placed thereon being set to be an inner peripheral face side; and
holding the wire on each of the plurality of wire holding concave portions whose width dimension is narrowed by folding molding.
